Europäisches Patentamt

European Patent Office

Office européen des brevets

(11) Veröffentlichungsnummer: **0 282 976 B1**

## EUROPÄISCHE PATENTSCHRIFT

(45) Veröffentlichungstag der Patentschrift: 09.10.91

(51) Int. Cl.5: **G11C 29/00**

(21) Anmeldenummer: **88104115.6**

(22) Anmeldetag: **15.03.88**

(54) Verfahren und Schaltungsanordnung zum parallelen Einschreiben von Daten in einen Halbleiterspeicher.

(30) Priorität: **16.03.87 DE 3708527**

(43) Veröffentlichungstag der Anmeldung:
**21.09.88 Patentblatt 88/38**

(45) Bekanntmachung des Hinweises auf die
Patenterteilung:
**09.10.91 Patentblatt 91/41**

(84) Benannte Vertragsstaaten:
**AT DE FR GB IT NL**

(56) Entgegenhaltungen:
**EP-A- 0 055 594**
**EP-A- 0 083 099**
**DE-A- 3 530 591**

**INTEGRATION THE VLSI JOURNAL, Band 2,
Nr. 4, Dezember 1984, Seiten 309-330, Elsevier Science Publishers B.V., Amsterdam,
NL; K.K. SALUJA et al.: "Testable design of
large random access memories"**

**IEEE TRANSACTIONS ON ELECTRON DEVI-
CES, Band ED-32, Nr. 2, Februar 1985, Seiten
508-515, IEEE, New York, US; Y. YOU et al.: "A
self-testing dynamic RAM chip"**

**IEEE JOURNAL OF SOLID-STATE CIRCUITS,
Band SC-21, Nr. 5, Oktober 1986, Seiten
635-642, IEEE, New York, US; H. McADAMS et
al.: "A 1-Mbit CMOS dynamic RAM with
design-for test functions"**

(73) Patentinhaber: **SIEMENS AKTIENGESELL-
SCHAFT
Wittelsbacherplatz 2
W-8000 München 2(DE)**

(72) Erfinder: **Oberle, Hans-Dieter, Dipl.-Ing.
Edelweissstrasse 82
W-8039 Puchheim(DE)**
Erfinder: **Kowarik, Oskar, Dr. rer. nat.
Goethering 70
W-8018 Grafing(DE)**
Erfinder: **Kraus, Rainer, Dipl.-Phys.
Weidener Strasse 21
W-8000 München 83(DE)**
Erfinder: **Paul, Manfred, Dipl.-Ing.
Fichtenstrasse 18
W-8043 Unterföhring(DE)**
Erfinder: **Hoffmann, Kurt, Dr. Prof.
Nelkenweg 20
W-8028 Taufkirchen(DE)**

**Beschreibung**

Die Erfindung betrifft ein Verfahren zum parallelen Einschreiben von Daten in Form eines Prüfmusters in Speicherzellen eines Halbleiterspeichers sowie eine Schaltungsanordnung insbesondere zur Durchführung des Verfahrens nach dem Oberbegriff des Patentanspruches 6.

Halbleiterspeicher, insbesondere integrierte Halbleiterspeicher vom RAM-Typ (DRAM,SRAM) weisen heute eine große Speicherkapazität auf (z.B. 1MB x 1). Bislang vervierfacht sich die realisierbare Speicherkapazität alle drei bis vier Jahre. Beim Testen solcher Halbleiterspeicher steigt bekanntlich der notwendige Zeitaufwand zur Durchführung der Prüfungen in Abhängigkeit von den an den Halbleiterspeicher anzulegenden Prüfmustern mindestens um den Faktor $2^N$ bei Zunahme der Speichergröße um den Faktor N an.

Um Testzeit zu sparen, wird in EP-A 01 86 040 vorgeschlagen, einen Halbleiterspeicher intern in mehrere gleiche Blöcke einzuteilen, diese im Testbetrieb parallel zu betreiben und über eine Auswerteschaltung den größten Teil der möglicherweise auftretenden Fehler zu erfassen. In der Praxis ist es möglich, einen Halbleiterspeicher in vier oder acht gleiche Blöcke in diesem Sinne einzuteilen, ohne daß der dazu notwendige Verdrahtungsmehraufwand und Schaltungsmehraufwand nennenswert ansteigt. Eine Einteilung in wesentlich mehr Blöcke erfordert jedoch erhöhten Schaltungs- und Verdrahtungsmehraufwand, was sich bei integrierten Halbleiterspeichern insbesondere auf den notwendigen Platzbedarf negativ auswirkt (Chipfläche).

Aus der US-A 4,055,754 ist eine Testschaltung bekannt, die spaltenparalleles Auslesen aller Speicherzellen an einer einzigen Wortleitung erlaubt, sofern alle Speicherzellen der auszulesenden Wortleitung gleiche Informationen enthalten sollen. Ein Einschreiben von Informationen in die Speicherzellen erfolgt jedoch traditionell.

Aus DE-A-3 530 591 ist es bekannt, Daten von einem externen Bitleitungspaar über Transfertransistoren und interne Bitleitungen in alle Speicherzellen parallel einzuschreiben, wenn die Bitleitungsdekoder ein Testmodus Signal erhalten.

Es ist Aufgabe der vorliegenden Erfindung, ein Verfahren zu finden, das ein Beschreiben von Speicherzellen eines Halbleiterspeichers in möglichst kurzer Zeit mit möglichst geringem Schaltungs- und Platzmehraufwand gegenüber bekannten Halbleiterspeichern ermöglicht. Es ist weiterhin Aufgabe der vorliegenden Erfindung, eine Schaltungsanordnung zu schaffen, die die Durchführung des erfindungsgemäßen Verfahrens ermöglicht.

Diese Aufgabe wird gelöst durch die Merkmale des Patentanspruches 1 und durch die kennzeichnenden Merkmale des Patentanspruches 6.

Nachfolgend wird die Erfindung anhand von Figuren näher erläutert. Es zeigen

FIG 1     eine erfindungsgemäße Schaltungsanordnung,

FIG 2     eine interne Bewerterschaltung nach dem Stande der Technik,

FIG 3     eine Umschalteeinrichtung,

FIG 4     eine weitere Ausbildung der Schaltungsanordnung.

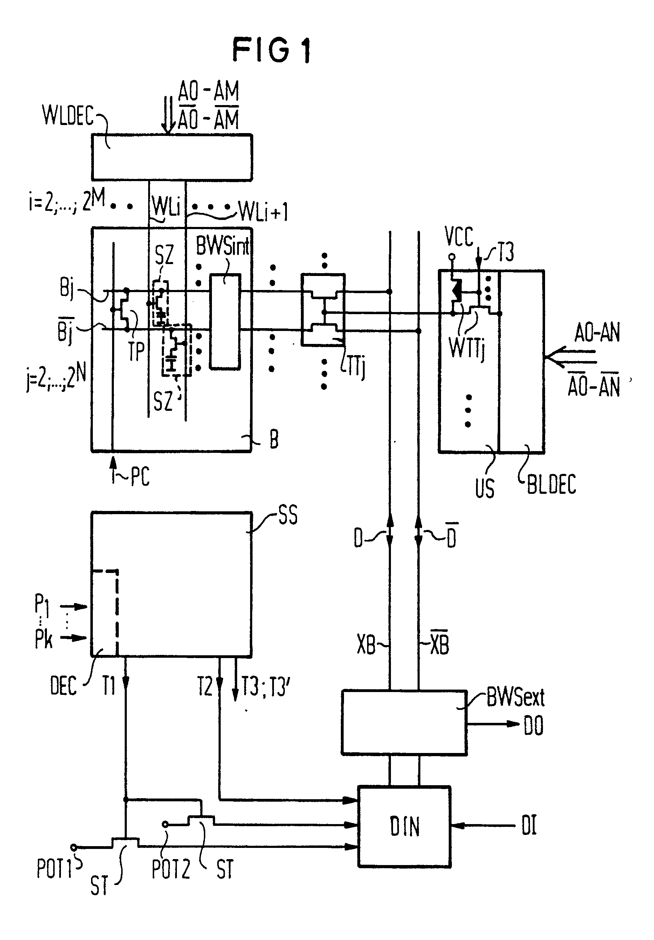

Die erfindungsgemäße Schaltungsanordnung nach FIG 1 zeigt einen Block B eines Halbleiterspeichers, der $2^{N+M}$ übliche Speicherzellen SZ enthält. Im Falle eines DRAM's als Halbleiterspeicher sind dies im allgemeinen sogenannte 1-Transistor-Speicherzellen. Die Speicherzellen SZ sind, wie allgemein üblich, in Form einer Matrix aus Zeilen und Spalten angeordnet. Die spaltenweise Adressierung erfolgt über Wortleitungen WLi, die zeilenweise Adressierung über Bitleitungen Bj,$\overline{Bj}$. Die aus den Speicherzellen SZ ausgelesenen Informationen werden in internen Bewerterschaltungen BWSint bewertet und vorverstärkt. Für jede Zeile von Speicherzellen SZ ist eine interne Bewerterschaltung BWSint vorgesehen.

Es sind prinzipiell zwei verschiedene Konzepte von Bitleitungsführung bekannt: zum einen das historisch ältere, sogenannte Open-Bitline-Konzept und zum anderen das sogenannte Folded-Bitline-Konzept. Beide Konzepte sind in US-A 4,044,340 erläutert und dargestellt. Die vorliegende Erfindung ist auf beide Bitleitungskonzepte anwendbar. Aus Gründen der einfacheren Darstellung ist sie jedoch nur anhand des Folded-Bitline-Konzeptes erläutert.

Allgemein ist jeder Bitleitung eine interne Bewerterschaltung BWSint zugeordnet. Dies bedeutet, daß beim Folded-Bitline-Konzept an jede interne Bewerterschaltung BWSint zwei parallel nebeneinander verlaufende Bitleitungshälften Bj,$\overline{Bj}$ als insgesamt eine einzige Bitleitung angeschlossen sind. Dieser Anordnung entsprechen jeweils eine linke und eine rechte Bitleitungshälfte und eine dazwischen angeordnete Bewerterschaltung beim Open-Bitline-Konzept. Im nachfolgenden werden die beiden Bitleitungshälften insgesamt als "interne Bitleitung Bj,$\overline{Bj}$" bezeichnet.

Die vorteilhafte Schaltungsanordnung weist außerdem eine externe Bewerterschaltung BWSext auf, an die eine externe Sammelbitleitung mit einer ersten (XB) und einer zweiten Sammelbitleitungshälfte ($\overline{XB}$) angeschlossen ist. Die externe Sammelbitleitung XB,$\overline{XB}$ ist jeweils über ein Transfertransistorpaar TTj mit jeder internen Bitleitung Bj,$\overline{Bj}$ und der zugehörigen internen Bewerterschaltung BWSint verbunden. Die externe Bewerterschaltung BWSext dient im Falle des Auslesens von Daten aus dem Halbleiterspeicher dem Verstärken des ausgelesenen, von einer der internen Bewerterschaltungen BWSint bewerteten und vorverstärkten Datums und auch der Weitergabe dieses Datums D0 beispielsweise an eine (nicht dargestellte) Datenausgangspufferschaltung.

Die externe Bewerterschaltung BWSext dient jedoch auch im Falle des Einschreibens von Daten DI in den Halbleiterspeicher der Übernahme des einzuschreibenden Datums DI von einer mit der externen Bewerterschaltung BWSext verbundenen Dateneingangsschaltung DIN und der Weitergabe an die externe Sammelbitleitung XB,$\overline{XB}$, von wo aus das Einschreiben über eine entsprechend aktivierte interne Bitleitung Bj,$\overline{Bj}$ in eine adressierte Speicherzelle SZ erfolgt.

Wie üblich, sind die Wortleitungen, WLi durch Wortleitungsdekoder WLDEC aktivierbar, d.h. auswählbar, und die internen Bitleitungen Bj,$\overline{Bj}$ durch Bitleitungsdecoder BLDEC und die bereits erwähnten Transfertransistorpaare TTj. In vorteilhafter Weise ist die Dateneingangsschaltung DIN weiterhin mit zwei Potentialen POT1,POT2 verbunden, die wertemäßig zwei zueinander komplementären logischen Pegeln D, $\overline{D}$ zugeordnet sind, denen wiederum die möglichen Signalwerte der einzuschreibenden Daten DI entsprechen. Im allgemeinen sind die Potentiale POT1,POT2 wertemäßig gleich den möglichen Signalwerten der Daten DI und sogar gleich den Versorgungsspannungen VCC,VSS des Halbleiterspeichers selbst. Dies ist jedoch nicht notwendig für die Realisierung der vorliegenden Erfindung. Die Verbindung der beiden Potentiale POT1,POT2 mit der Dateneingangsschaltung DIN erfolgt über jeweils einen Schalttransistor ST.

Die erfindungsgemäße Schaltungsanordnung weist weiterhin eine Steuerschaltung SS auf. Sie ist eingangsseitig mit Steuersignalen P1 bis Pk verbunden. Im praktischen Betrieb der Schaltungsanordnung enthalten die Steuersignale P1 bis Pk Informationen darüber, ob paralleles Einschreiben durchgeführt werden soll und welches Prüfmuster beim parallelen Einschreiben zu verwenden ist. Ein erstes Ausgangssignal T1 der Steuerschaltung SS steuert die Schalttransistoren ST gatemäßig an. Ein Durchschalten der Schalttransistoren ST mittels des ersten Ausgangssignales T1 erfolgt nur dann, wenn Speicherzellen SZ des angesteuerten Blockes B parallel zueinander beschrieben werden sollen.

Ein zweites Ausgangssignal T2 ist mit der Dateneingangsschaltung DIN verbunden. Es steuert im Falle parallelen Einschreibens innerhalb der Dateneingangsschaltung DIN, welches der über die Schalttransistoren ST angelegten Potentiale POT1,POT2 als logischer Pegel D über die externe schaltung BWSext an die erste Hälfte XB der externen Sammelbitleitung XB,$\overline{XB}$ anzulegen ist und welches der über die Schalttransistoren ST angelegten Potentiale POT1, POT2 als logischer Pegel $\overline{D}$ über die externe Bewerterschaltung BWSext an

die zweite Hälfte $\overline{XB}$ der externen Sammelbitleitung XB,$\overline{XB}$ anzulegen ist. Der Wert der logischen Pegel D und $\overline{D}$ ist durch das in den Speicher einzuschreibende Prüfmuster und die gerade aktuelle Adressierung von Speicherzellen SZ bestimmt.

Eine Umschalteeinrichtung US ermöglicht ein gleichzeitiges Ansteuern von mehreren oder allen internen Bitleitungen Bj,$\overline{Bj}$ über die zugehörigen Transfertransistorpaare TTj. Die Umschalteeinrichtung US enthält erfindungsgemäß beispielsweise je Ausgang der Bitleitungsdecoder BLDEC, d.h. je interner Bitleitung Bj,$\overline{Bj}$ ein Paar weiterer Transfertransistor WTTj. Der eine weitere Transfertransistor eines solchen Paares WTTj ist beispielsweise als n-Kanal-Transistor ausgebildet. Er ist mit Source und Drain zwischen den zugeordneten Dekoderausgang des Bitleitungsdekoders BLDEC und die Gates des der jeweiligen Bitleitung Bj,$\overline{Bj}$ zugeordneten Transfertransistorpaares TTj geschaltet. Der andere weitere Transfertransistor eines solchen Paares WTTj ist entsprechend beispielsweise als p-Kanal-Transistor ausgebildet. Er ist sourcemäßig mit dem Versorgungspotential VCC des Halbleiterspeichers verbunden und drainmäßig mit den Gates des entsprechenden Transfertransistorpaares TTj. Beide Transistoren des weiteren Transfertransistorpaares WTTj sind an ihren Gates mit einem dritten Ausgangssignal T3 der Steuerschaltung SS verbunden. In einer ersten Ausführungsform der Umschalteinrichtung US, dargestellt in FIG 1, sind die Gates aller weiteren Transfertransistorpaare WTTj mit einem einzigen Ausgangssignal T3 der Steuerschaltung SS verbunden. Im Normalbetrieb ist das dritte Ausgangssignal T3 aktiviert, so daß die n-Kanal-Transistoren aller weiteren Transfertransistorpaare WTTj durchgeschaltet sind, d.h. die Gates der Transfertransistorpaare TTj werden mit den Signalen angesteuert, die die Ausgänge der Bitleitungsdekoder BLDEC aufweisen.

Im Testbetrieb, zum parallelen Einschreiben von Daten in mehrere Speicherzellen SZ an mindestens einer Wortleitung WLi ist das dritte Ausgangssignal T3 deaktiviert, so daß zwar alle n-Kanal-Transistoren der weiteren Transfertransistorpaare WTTj sperren. Es leiten jedoch die entsprechenden p-Kanal-Transistoren. Die Gates aller Transfertransistorpaare TTj erhalten das Potential VCC, d.h. alle Transfertransistorpaare TTj schalten durch. Somit kann in alle Speicherzellen SZ, die mit einer aktivierten Wortleitung WLi verbunden sind, das über die externe Sammelbitleitung XB,$\overline{XB}$ anstehende Datum D,$\overline{D}$ eingeschrieben werden. Damit lassen sich einfache Prüfmuster wie "All 0's"; "All 1's"; "eine Hälfte'0' und eine Hälfte '1'" in einen Block B eines Halbleiterspeichers sehr schnell und ohne nennenswerten Flächenmehraufwand einschreiben.

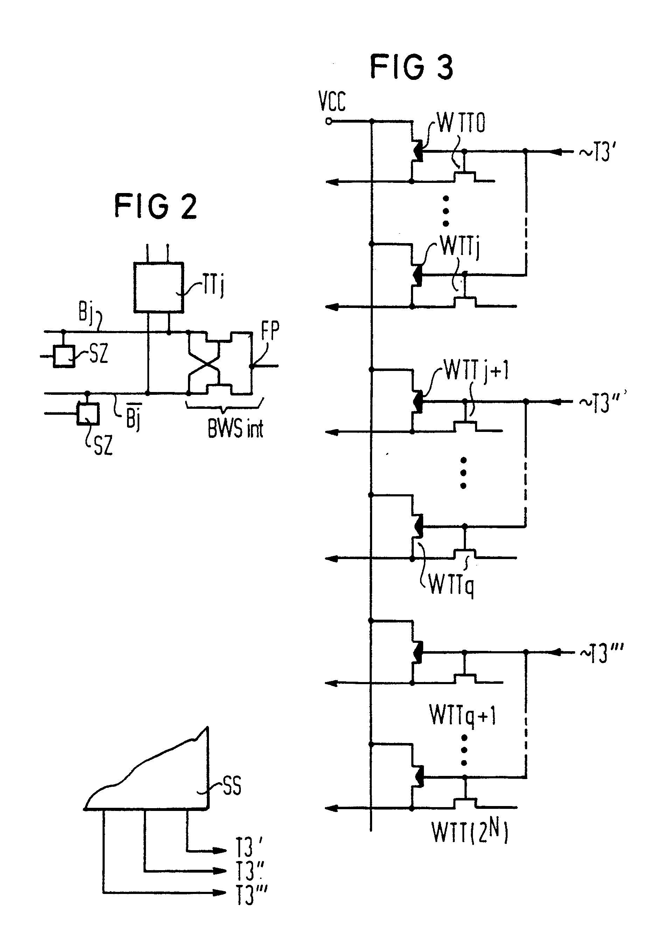

In einer weiteren, vorteilhaften Ausführungsform (vgl. FIG 3) der Umschalteeinrichtung US sind die Gates der weiteren Transfertransistorpaare WTTj nicht insgesamt mit dem dritten Ausgangssignal T3 der Steuerschaltung SS verbunden. Anstelle dessen weist die Steuerschaltung SS mehrere, d.h. wenigstens zwei voneinander unabhängige dritte Ausgangssignale T3 auf (im dargestellten Fall drei Signale T3', T3", T3‴). Außerdem sind die Gateanschlüsse der weiteren Transfertransistorpaare WTTj in mehrere, d.h. wenigstens zwei voneinander unabhängige Gruppen zusammengefaßt (in FIG 3: drei Gruppen), wobei jede Gruppe mit einem der dritten Ausgangssignale T3 (FIG 3: T3', T3", T3‴) verbunden ist. Damit lassen sich auch kompliziertere Prüfmuster wie z.B. Checkerboard in die Speicherzellen einer aktuellen Wortleitung WLi einschreiben.

In diesem Zusammenhang wird ausdrücklich auf die im Zeitrang gleichen Schutzrechte mit den amtlichen Aktenzeichen 88104113.1 und 88104117.2 hingewiesen. Die dort vorgestellten Bitleitungsdecoder vermögen vorteilhaft die Bitleitungsdecoder BLDEC und die Umschalteeinrichtung US der vorliegenden Erfindung zu ersetzen und ermöglichen es auf einfache Art und Weise, verschiedene Bitmuster parallel in alle Speicherzellen SZ einer Wortleitung WL einzuschreiben.

Anhand der erfindungsgemäßen Schaltungsanordnung läßt sich nun das erfindungsgemäße Verfahren relativ einfach erläutern:

Soll in einen Block B eines Halbleiterspeichers ein Prüfmuster zu Testzwecken, beispielsweise "All 0's" eingeschrieben werden, so läßt sich das erfindungsgemäße Verfahren wie folgt anwenden:

Zunächst werden alle internen Bewerterschaltungen BWSint inaktiv geschaltet. Dies kann bei heutzutage üblicherweise verwendeten internen Bewerterschaltungen BWSint aus kreuzgekoppelten Transistoren (vgl. FIG 2) dadurch geschehen, daß der gemeinsame Fußpunkt FP jeder internen Bewerterschaltung BWSint zunächst auf hohem Potential gehalten wird (positive Logik wie z.B. bei CMOS- oder n-Kanal-Technologie). Anschließend werden, wie allgemein üblich, alle internen Bitleitungen Bj,B̄j auf einen Vorladepegel vorgeladen, der durch das verwendete Ausleseprinzip festgelegt ist. Während es früher üblich war, auf die Versorgungspotentiale VSS bzw. VCC vorzuladen, wird heutzutage zunehmend das sogenannte Mid-Level-Konzept verwendet, bei dem auf die halbe Versorgungsspannung (VSS + VCC)/2 vorgeladen wird. Das Vorladen, das in FIG 1 beispielsweise nach dem Mid-Level-Konzept erfolgen soll, wird von einem Vorladeimpuls PC über Vorladetransistoren TP durchgeführt. Näheres Eingehen darauf erübrigt sich, da das Vorladen nach dem Stande der Technik erfolgt.

Spätestens nach Beenden des Vorladens werden an die Steuerschaltung SS, die nachfolgend noch näher beschrieben wird, Steuersignale P1 bis Pk angelegt. Diese bestimmen anhand der Steuerschaltung SS, ob paralleles Einschreiben von Daten in mehrere Speicherzellen SZ einer Wortleitung WLi gleichzeitig gewünscht ist und wenn ja, welches Prüfmuster zu verwenden ist. Im vorliegenden Falle wird ein erstes Ausgangssignal T1 aktiviert, das die Schalttransistoren ST durchschaltet und so die Potentiale POT1 und POT2 an die Dateneingangsschaltung DIN legt. Ein zweites Ausgangssignal T2 der Steuerschaltung SS wird an die Dateneingangsschaltung DIN gelegt. Die Dateneingangsschaltung DIN legt mittels der Potentiale POT1 und POT2 über die externe Bewerterschaltung BWSext an die erste Hälfte XB der externen Sammelbitleitung XB,X̄B einen bestimmten logischen Pegel D und an die zweite Hälfte X̄B der externen Sammelbitleitung XB,X̄B einen zu diesem bestimmten logischen Pegel D komplementären logischen Pegel D̄ an. Welcher logische Zustand (0 oder 1) als logischer Pegel D an die erste Hälfte XB gelegt wird und welcher logische Pegel D̄ entsprechend an die zweite Hälfte X̄B der externen Sammelbitleitung XB,X̄B gelegt wird, entscheidet der Zustand des zweiten Ausgangssignales T2. Dieser wird über die Steuerschaltung SS durch die Steuersignale P1 bis Pk festgelegt, da über die Steuersignale P1 bis Pk festgelegt ist, welches Prüfbitmuster in den Halbleiterspeicher einzuschreiben ist. Er ist wegen der Abhängigkeit vom Prüfmuster abhängig von der Aktivierung der Wortleitungen WLi über die Wortleitungsdekoder WLDEC.

Im vorliegenden Beispiel werde an die erste Hälfte XB der externen Sammelbitleitung XB,X̄B eine logische "1" angelegt. Demzufolge wird an die zweite Hälfte X̄B der externen Sammelbitleitung XB,X̄B eine logische "0" angelegt. Anschließend werden, gesteuert durch die weiteren Transfertransistorpaare WTTj der Umschalteeinrichtung US für wenigstens zwei interne Bewerterschaltungen BWSint und maximal alle internen Bewerterschaltungen BWSint die diesen zugeordneten Transfertransistorpaare TTj elektrisch leitend geschaltet. Dadurch gelangen die an der externen Sammelbitleitung XB,X̄B anliegenden einzuschreibenden Daten D,D̄ in Form von logischen Pegeln an die mit den durchgeschalteten Transfertransistorpaaren TTj verbundenen internen Bitleitungen Bj,B̄j und die (inaktiv geschalteten) internen Bewerterschaltungen BWSint. Jetzt wird eine Wortleitung WLi aktiviert. Dadurch erfolgt das Einschreiben der Daten D,D̄ in alle Speicherzellen SZ, die einerseits mit der aktivierten Wortleitung WLi und andererseits mit denjenigen internen Bitleitungen Bj,B̄j verbunden sind, deren zugehörige Transfertransistorpaare TTj elektrisch leitend geschaltet sind. Dann wird die Wortleitung WLi wieder deaktiviert.

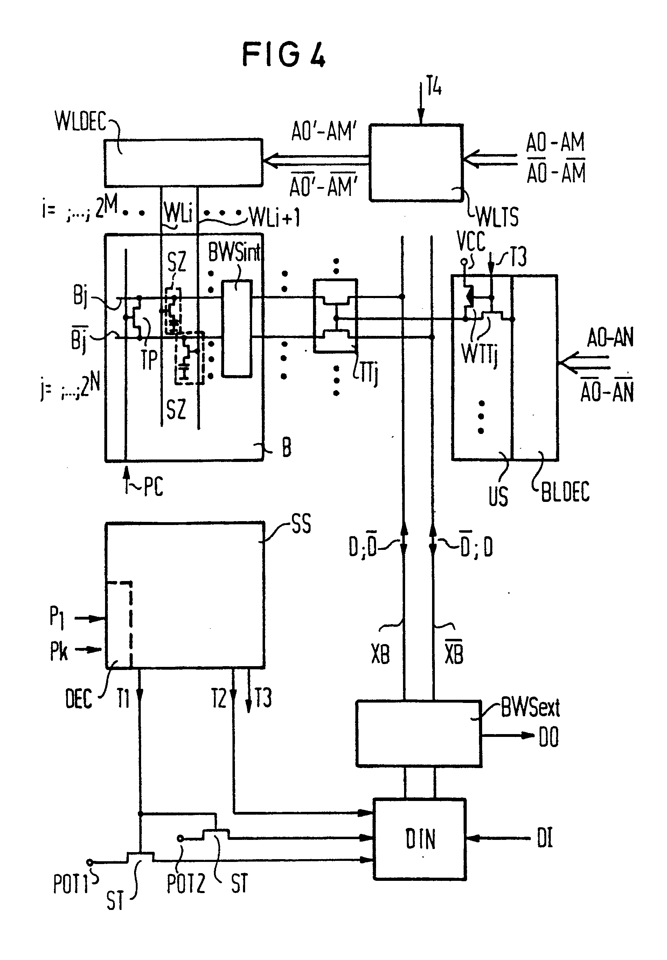

Sollen die Daten D,$\overline{D}$, die sich auf den ersten und zweiten Hälften der externen Sammelbitleitung XB,$\overline{XB}$ befinden, in Speicherzellen SZ eingeschrieben werden, die mit anderen als der bereits aktivierten Wortleitung WLi verbunden sind, so werden diese anderen Wortleitungen WLi nacheinander aktiviert und wieder deaktiviert, wodurch das Einschreiben erfolgt. Weist der Block B des Halbleiterspeichers Wortleitungsdekodiereinrichtungen auf, die es ermöglichen, mehr als eine Wortleitung WLi gleichzeitig zu aktivieren (vgl. FIG 4), so werden diejenigen Speicherzellen SZ, die zwar mit gleichen Daten wie sie die beiden Hälften der externen Sammelbitleitung XB,$\overline{XB}$ aufweisen, zu beschreiben sind, die aber an verschiedenen Wortleitungen WLi angeordnet sind, gleichzeitig beschrieben, indem die betroffenen Wortleitungen WLi gleichzeitig aktiviert und deaktiviert werden, soweit dies die Wortleitungsdekoder WLDEC ermöglichen.

Unter idealen Voraussetzungen (alle Wortleitungen WLi sind gleichzeitig aktivierbar (beispielsweise mittels einer Vorrichtung ähnlich der Umschalteeinrichtung US); in alle Speicherzellen SZ, die mit der ersten Hälfte ihrer ihnen zugeordneten Bitleitungen, Bj,$\overline{Bj}$ verbunden sind, soll eine logische '1' (logisch '0') eingeschrieben werden; in alle Speicherzellen SZ, die mit der zweiten Hälfte ihrer ihnen zugeordneten Bitleitungen Bj,$\overline{Bj}$ verbunden sind, soll der dazu komplementäre Wert logisch '0' (logisch '1') eingeschrieben werden; alle Trenntransistorpaare TTj sind gleichzeitig elektrisch leitend schaltbar) genügt so ein einziger Zyklus, um alle Speicherzellen SZ des Blockes B des Halbleiterspeichers gleichzeitig zu beschreiben. Dazu sind jedoch hohe Ströme notwendig, was in der Praxis zu einer Verlängerung dieses Schreibzyklus gegenüber herkömmlichen Schreibzyklen führt. Dadurch wird die notwendige Energiezufuhr auf einen längeren Zeitraum unkritisch verteilt.

Im vorliegenden, vom verwendeten Prüfmuster her (All '1'-s) bewußt sehr einfach gehaltenen Beispiel ist es jedoch so, daß diejenigen Speicherzellen SZ, die mit der zweiten Hälfte $\overline{Bj}$ ihrer jeweiligen internen Bitleitung verbunden sind, nicht notwendigerweise beschrieben werden brauchen, weil diese zweite Hälfte den Zustand logisch 0 aufweist. Im vorliegenden Beispiel werden also diejenigen Speicherzellen SZ, die mit der ersten Hälfte Bj ihrer jeweiligen internen Bitleitung verbunden sind, gleichzeitig oder nacheinander beschrieben, jedoch immer mehrere bis alle Speicherzellen SZ an einer Wortleitung WLi gleichzeitig.

Ist dies erfolgt, so müssen die internen Bitleitungen Bj, $\overline{Bj}$ umgeladen werden, d.h. sie müssen einen zu ihrem bisherigen logischen Zustand (Bj: D = 1, $\overline{Bj}$: $\overline{D}$ = 0) komplementären logischen Zustand (Bj: D = 0,$\overline{Bj}$: $\overline{D}$ = 1) erreichen. Dazu werden zunächst alle internen Bitleitungen Bj,$\overline{Bj}$

über die Vorladetransistoren TP, wie zuvor bereits beschrieben, auf ihre Vorladepegel vorgeladen. Jetzt wird die erste Hälfte XB der externen Sammelbitleitung mit dem gegenüber ihrem bisherigen Pegel (logisch 1) komplementären Pegel logisch 0 geladen und entsprechend die zweite Hälfte $\overline{XB}$ der externen Sammelbitleitung mit dem gegenüber ihrem bisherigen Pegel (logisch '0') komplementären Pegel logisch '1' geladen. Dies erfolgt über die Dateneingangsschaltung DIN in Verbindung mit dem zweiten Ausgangssignal T2 der Steuerschaltung SS, das jetzt einen komplementären logischen Zustand aufweist gegenüber seinem bisherigen Zustand.

Ab diesem Zeitpunkt wird für die verbliebenen, noch zu beschreibenden Speicherzellen SZ analog verfahren wie zuvor bereits beschrieben: Zunächst werden für wenigstens zwei bis maximal alle internen Bewerterschaltungen BWSint die diesen internen Bewerterschaltungen BWSint zugehörigen Transfertransistorpaare TTj elektrisch leitend geschaltet, sodaß die logischen Pegel D,$\overline{D}$ der externen Sammelbitleitung XB,$\overline{XB}$ über die elektrisch leitend geschalteten Transfertransistorpaare TTj auf die internen Bitleitungen Bj,$\overline{Bj}$ gelangen. Anschließend werden diejenigen Wortleitungen WLi, deren daran angeschlossene Speicherzellen SZ zuvor noch nicht (oder mit einem nicht gewünschten Datum) beschrieben wurden, entweder einzeln oder in Gruppen hintereinander oder alle gleichzeitig angesteuert, sodaß die über die internen Bitleitungen Bj,$\overline{Bj}$ und die Wortleitungen WLi angesteuerten Speicherzellen SZ beschrieben werden.

Auf diese Weise lassen sich insgesamt sehr schnell und ohne großen Schaltungs- und Platzaufwand sämtliche Speicherzellen eines Halbleiterspeichers im Testfall beschreiben, indem beispielsweise jeweils alle Speicherzellen SZ an einer Wortleitung WLi gleichzeitig mit einfachen, regelmäßig aufgebauten Prüfmustern beschrieben werden. Bei einem modernen DRAM als Halbleiterspeicherbaustein wie z.B. 1MB-DRAM mit 1024 Worten x 1024 Spalten werden, um das zuvor beispielhaft angenommene Prüfmuster "All 1's" einzuschreiben, anstelle von 1024 x 1024 = 1'048.576 Schreibzyklen nur 1024 Schreibzyklen benötigt, wenn jede Wortleitung WLi einzeln angesteuert wird, jedoch pro Wortleitung WLi jeweils alle daran angeschlossenen Speicherzellen SZ beschrieben werden.

In vorteilhafter Weiterbildung der Erfindung werden zumindest diejenigen internen Bewerterschaltungen BWSint, deren zugehörige Transfertransistorpaare TTj elektrisch leitend geschaltet werden, nach dem Leitendschalten der Transfertransistorpaare aktiv geschaltet, sodaß sie ihre (im Lesebetrieb sowieso übliche) Verstärkungsfunktion hinsichtlich der logischen Signale D,$\overline{D}$ auf der ihnen zugeordneten internen Bitleitung Bj,$\overline{Bj}$ erfüllen

können. Dadurch wird die Übernahme der logischen Pegel D,$\overline{D}$ der externen Sammelbitleitung XB, $\overline{XB}$ auf die entsprechenden internen Bitleitungen Bj,$\overline{Bj}$ beschleunigt. Diese Weiterbildung bedingt allerdings, daß vor dem Wechsel der logischen Pegel D,$\overline{D}$ auf den externen Sammelbitleitungen XB,$\overline{XB}$ die internen Bewerterschaltungen BWSint erst deaktiviert werden müssen, damit das anschließende Vorladen der internen Bitleitungen Bj,$\overline{Bj}$ durchgeführt werden kann.

Es ist weiterhin von Vorteil, daß es bei Halbleiterspeichern, deren Speicherzellen SZ in einzelne, einander gleiche Blöcke B eingeteilt sind, beispielsweise auch im Sinne der EP-A 0 186 040, je Block B durchgeführt wird, wobei das Verfahren für alle Blöcke B zeitlich parallel im Sinne von EP-A 0 186 040 durchgeführt wird. Damit ist es dann beispielsweise möglich, in einem Block B alle Speicherzellen SZ, die an einer Wortleitung WLi angeordnet sind, mit Daten zu beschreiben und gleichzeitig in jedem der anderen Blöcke B alle Speicherzellen SZ derjenigen Wortleitung WLi, die in ihrer Adressierung innerhalb ihres Blockes B derjenigen des erstgenannten Blockes B entspricht, ebenfalls zu beschreiben.

Die vorteilhafte Anordnung zur Durchführung des Verfahrens wurde zuvor bereits beschrieben. In Weiterbildung der Erfindung ist es nun vorteilhaft, daß die Steuerschaltung SS einen Dekodierteil DEC enthält, der die Steuersignale P1 bis Pk auswertet. Der Dekodierteil DEC erkennt zum einen, ob paralleles Einschreiben in Speicherzellen SZ einer Wortleitung WLi gewünscht ist. Zum anderen erkennt er, welches von verschiedenen möglichen Prüfmustern gewünscht ist.

Die Steuersignale P1 bis Pk können Signale sein, die über separate Anschlüsse an den Halbleiterspeicher angelegt werden. Sie können aber auch Signale sein, die über am Halbleiterspeicher sowieso schon vorhandene Anschlüsse geführt werden, beispielsweise über Adreßsignalanschlüsse. In diesem Fall ist es notwendig, daß der Dekodierteil DEC so ausgelegt ist, daß er erkennen kann, ob 'normale' Adreßsignale am Halbleiterspeicher extern anliegen oder ob die Steuersignale P1 bis Pk im Sinne der vorliegenden Erfindung anliegen. Zur Lösung dieses Problems bieten sich dem Fachmann mehrere Möglichkeiten: Zum einen kann der Dekodierteil DEC so ausgelegt sein, daß er extern am Halbleiterspeicher anliegende Signale dann als Steuersignale P1 bis Pk erkennt, wenn (mindestens) eines davon einen gegenüber den im Halbleiterspeicher ansonsten üblichen logischen Pegeln deutlich überhöhten Signalpegel aufweist. Dies läßt sich beispielsweise mittels einer Spannungsdiskriminatorschaltung ermitteln (vgl. auch EP-B 0 046 215). Es ist jedoch auch möglich, an den Halbleiterspeicher zunächst eine spezielle Signalkombination und Signalfolge anzulegen, die über den Dekodierteil DEC den Halbleiterspeicher in einen Testbetrieb umschaltet, innerhalb dessen das vorstehend beschriebene parallele Einschreiben von Daten erfolgen kann. Nach erfolgter Testdurchführung wird an den Halbleiterspeicher eine weitere, spezielle Signalkombination und Signalfolge angelegt, die den Halbleiterspeicher (und damit auch die Steuerschaltung SS) wieder in den Normalbetrieb zurückschaltet. Entsprechende Signalkombinationen und Signalfolgen zur Steuerung und zum Auslösen von Spezialfunktionen eines Halbleiterspeichers sind der Fachwelt bereits bekannt. Beispielsweise fand vom 9. bis 11. September 1986 in Minneapolis/USA ein "JEDEC Mos Memory Meeting" statt, bei dem über eine künftige Norm hinsichtlich solcher Signalkombinationen und Signalfolgen beraten wurde.

Der Kern der Steuerschaltung SS enthält vorteilhafterweise eine PLA-Schaltung. Diese enthält im wesentlichen Informationen über die vom Halbleiterspeicher-Hersteller vorgesehenen Prüfmuster. Die PLA-Schaltung wird vom Dekodierteil DEC, der ja die Steuersignale P1 bis Pk auswertet, bei Erkennen der Betriebsart "parallel Einschreiben in mehrere Zellen eines Blockes" mittels vom Dekodierteil DEC erzeugter interner Steuersignale angesteuert. Sie generiert in Abhängigkeit von ihrer Schaltungsauslegung und der internen Steuerschaltung die Ausgangssignale T1 ... der Steuerschaltung SS.

Anstelle der PLA-Schaltung kann die Steuerschaltung SS auch einen nicht flüchtigen Speicherbereich vom Typ ROM, PROM, etc. aufweisen. Seine Funktion ist analog der der PLA-Schaltung.

In einer vorteilhaften Weiterbildung der Erfindung, dargestellt in FIG 4, ist den Wortleitungsdekodern WLDEC eine Wortleitungs-Adreßtrennerschaltung WLTS vorgeschaltet. Sie ist eingangsseitig einerseits mit einem vierten Ausgangssignal T4 der Steuerschaltung SS verbunden und andererseits mit Adreßleitungen A0 bis AM,$\overline{A0}$ bis $\overline{AM}$, die üblicherweise der Adressierung der Wortleitungen WLi über die Wortleitungsdekoder dienen. Im Normalbetrieb sind die Adreßleitungen A0 bis AM,$\overline{A0}$ bis $\overline{AM}$ auf die Wortleitungsdekoder WLDEC durchgeschaltet, sodaß die Wortleitungsdekoder WLDEC von extern an den Halbleiterspeicher angelegten Adreßsignalen ansteuerbar sind. Im Falle von parallelem Einschreiben von Daten in mehrere Speicherzellen SZ mindestens einer Wortleitung WLi, d.h. also im Testbetrieb, bewirkt das vierte Ausgangssignal T4 der Steuerschaltung SS in einer ersten Ausführungsform der Wortleitungs-Adreßtrennerschaltung WLTS, daß diese die Wortleitungsdekoder WLDEC so ansteuert, daß die Wortleitungen WLi einzeln nacheinander aktiviert werden zum Einschreiben der Daten. In einer zweiten Ausführungsform werden die Wortleitungen WLi gruppenweise nacheinander aktiviert. In einer dritten Ausführungsform werden alle Wortleitungen WLi gleichzeitig aktiviert zum Einschreiben. Aufgrund des dabei auftretenden hohen Energiebedarfs ist in einem solchen Fall einerseits die Spannungsversorgung des Halbleiterspeichers entsprechend kräftig auszulegen und andererseits ist zu erwarten, daß der (einzige) Einschreibzyklus etwas länger dauert als üblich aufgrund des erhöhten Energiebedarfes des Halbleiterspeichers.

**Patentansprüche**

1. Verfahren zum parallelen Einschreiben von Daten in Form eines Prüfmusters in einen Block von mehreren Speicherzellen eines Halbleiterspeichers mit folgenden Merkmalen:
   a) Alle internen Bewerterschaltungen (BWSint) werden inaktiv geschaltet,
   b) alle internen Bitleitungen $(Bj,\overline{Bj})$ werden auf einen Vorladepegel vorgeladen,
   c) die erste Hälfte (XB) einer externen Sammelbitleitung wird auf einen ersten logischen Pegel (D) aufgeladen und die zweite Hälfte $(\overline{XB})$ der externen Sammelbitleitung wird auf einen zweiten logischen Pegel $(\overline{D})$ aufgeladen, der zum ersten logischen Pegel (D) komplementär ist, wobei mindestens einer der logischen Pegel $(D,\overline{D})$ den einzuschreibenden Daten entspricht,
   d) für wenigstens zwei interne Bewerterschaltungen (BWSint) und maximal alle internen Bewerterschaltungen (BWSint) wird ein der internen Bewerterschaltung (BWSint) jeweils zugehöriges Transfertransistorpaar (TTj) elektrisch leitend geschaltet, wodurch die an der externen Sammelbitleitung $(XB,\overline{XB})$ anliegenden logischen Pegel $(D,\overline{D})$ an die mit den durchgeschalteten Transfertransistorpaaren (TTj) verbundenen internen Bitleitungen $(Bj,\overline{Bj})$ gelangen,
   e) unter Ansteuerung wenigstens einer Wortleitung (WLi) erfolgt Einschreiben der gewünschten Daten in diejenigen Speicherzellen (SZ), die sowohl mit einer angesteuerten Wortleitung (WLi) verbunden sind als auch mit solchen internen Bitleitungen $(Bj,\overline{Bj})$, deren zugehöriges Transfertransistorpaar (TTj) elektrisch leitend geschaltet ist,
   f) Schritt (e) wird so oft durchgeführt unter Ansteuerung von jeweils mindestens einer zuvor noch nicht angesteuerten Wortleitung (WLi), bis alle diejenigen Speicherzellen (SZ) des Blockes (B) des Halbleiterspeichers beschrieben sind, deren Beschreiben aufgrund der gewählten Zuordnung zwischen der externen Sammelbitleitung $(XB,\overline{XB})$ und den beiden logischen Pegeln $(D,\overline{D})$ möglich ist,
   g) Wiederholen der Schritte ab Merkmal b) unter Vertauschen der ursprünglich gewählten Zuordnung zwischen der externen Sammelbitleitung $(XB,\overline{XB})$ und den beiden logischen Pegeln $(D,\overline{D})$, falls mit letztmaligem Abarbeiten von Merkmal f) noch nicht alle Speicherzellen (SZ) mit dem gewünschten Prüfmuster beschrieben sind.

2. Verfahren nach Anspruch 1, **dadurch gekennzeichnet,** daß zur Beschleunigung des Einschreibens der Daten in die Speicherzellen (SZ) nach dem Schritt d) des Patentanspruches 1 mindestens diejenigen internen Bewerterschaltungen (BWSint) aktiv geschaltet werden, deren zugehörige Transfertransistorpaare (TTj) elektrisch leitend geschaltet sind und daß das Wiederholen von Schritten gemäß Merkmal g) des Patentanspruches 1 bereits ab Merkmal a) des Patentanspruches 1 geschieht.

3. Verfahren nach Anspruch 1 oder Anspruch 2, **dadurch gekennzeichnet,** daß als erster logischer Pegel (D) beim ersten Durchlauf des Verfahrens die logische "0" gewählt wird.

4. Verfahren nach Anspruch 1 oder 2, **dadurch gekennzeichnet,** daß als erster logischer Pegel (D) beim ersten Durchlauf des Verfahrens die logische '1' gewählt wird.

5. Verfahren nach einem der vorhergehenden Ansprüche, **dadurch gekennzeichnet,** daß es bei Halbleiterspeichern mit mehreren, einander gleichen Speicherblöcken (B) auf diese Speicherblöcke (B) gleichzeitig parallel angewandt wird.

6. Schaltungsanordnung, insbesondere zur Durchführung des Verfahrens nach einem der vorhergehenden Ansprüche, aufweisend folgende Merkmale:
   - Ein Halbleiterspeicher enthält wenigstens einen Block (B) von in Form einer Matrix angeordneten $2^{N+M}$ Speicherzellen (SZ),
   - die Speicherzellen (SZ) sind über Wortleitungen (WLi) und interne Bitleitungen $(Bj,\overline{Bj})$ adressierbar,
   - jeder internen Bitleitung $(Bj,\overline{Bj})$ ist eine interne Bewerterschaltung (BWSint) zugeordnet, die die interne Bitleitung $(Bj,\overline{Bj})$ in zwei Hälften teilt,
   - jede interne Bewerterschaltung (BWSint) ist über ein Transfertransistorpaar (TTj) mit einer allen Transfertransistorpaaren (TTj) gemeinsamen externen Sammelbitleitung (XB,$\overline{XB}$) verbunden,

- an der externen Sammelbitleitung
  (XB,$\overline{XB}$) ist eine externe Bewerterschaltung (BWSext) angeschlossen, die sowohl im Falle des Auslesens von Daten
  aus dem Halbleiterspeicher dem Verstärken des ausgelesenen Datums und letztendlich der Weitergabe des verstärkten
  Datums (D0) dient als auch im Falle des
  Einschreibens von Daten in Form von
  logischen Pegeln (D,$\overline{D}$) in den Halbleiterspeicher der Übernahme des einzuschreibenden Datums von einer Dateneingangsschaltung (DIN) und der Weitergabe an die externe Sammelbitleitung
  (XB,$\overline{XB}$),

- die Wortleitungen (WLi) sind durch Wortleitungsdekoder (WLDEC) aktivierbar und
  die internen Bitleitungen (Bj,$\overline{Bj}$) durch
  Bitleitungsdekoder (BLDEC),

**gekennzeichnet durch** folgende Merkmale:

- die Dateneingangsschaltung (DIN) ist
  über je einen Schalttransistor (ST) mit
  Potentialen (POT1,POT2) verbunden, die
  wertemäßig den beiden logischen Pegeln
  (D,$\overline{D}$) zugeordnet sind,

- eine Steuerschaltung (SS) ist eingangsseitig mit Steuersignalen (P1, ..., Pk) verbunden,

- die Steuersignale (P1,...,Pk) enthalten Informationen, ob paralleles Einschreiben
  durchgeführt werden soll und welches
  Prüfmuster dabei verwendet werden soll,

- die Steuerschaltung (SS) weist ein erstes
  Ausgangssignal (T1) auf, das die Schalttransistoren (ST) ansteuert,

- sie weist ein zweites Ausgangssignal
  (T2) auf, das mit der Dateneingangsschaltung (DIN) verbunden ist und das
  innerhalb der Dateneingangsschaltung
  (DIN) steuert, welches der über die
  Schalttransistoren (ST) angelegten Potentiale (POT1,POT2) als erster logischer
  Pegel (D) über die externe Bewerterschaltung (BWSext) an eine erste Hälfte
  (XB) der externen Sammelbitleitung anzulegen ist und das weiterhin steuert,
  welches der über die Schalttransistoren
  (ST) angelegten Potentiale (POT1,POT2)
  als zweiter logischer Pegel ($\overline{D}$) über die
  externe Bewerterschaltung (BWSext) an
  eine zweite Hälfte ($\overline{XB}$) der externen
  Sammelbitleitung anzulegen ist,

- die Bitleitungsdekoder (BLDEC) sind mit
  einer Umschalteeinrichtung (US) versehen zur parallelen Aktivierung mindestens mehrerer bis maximal aller Transfertransistorpaare (TTj) über ein drittes
Ausgangssignal (T3) der Steuerschaltung
(SS).

7. Schaltungsanordnung nach Anspruch 6, **dadurch gekennzeichnet**, daß die Steuerschaltung (SS) einen Dekodierteil (DEC) enthält, der
die Steuersignale (P1,...,Pk) auswertet.

8. Schaltungsanordnung nach Anspruch 6 oder 7,
**dadurch gekennzeichnet**, daß die Steuerschaltung (SS) eine PLA-Schaltung enthält.

9. Schaltungsanordnung nach Anspruch 6 oder 7,
**dadurch gekennzeichnet**, daß die Steuerschaltung (SS) eine nicht flüchtige Speicherschaltung enthält.

10. Schaltungsanordnung nach einem der Ansprüche 6 bis 9, **dadurch gekennzeichnet**, daß
die Umschalteeinrichtung (US) ein weiteres
Transfertransistorpaar (WTTj) mit zwei zueinander komplementären Transistoren je interne
Bitleitung (Bj,$\overline{Bj}$) aufweist, daß je weiterem
Transistorpaar (WTTj) Source und Drain des
einen Transistors zwischen den Gateanschlüssen des Transfertransistorpaares (TTj) einer internen Bitleitung (Bj,$\overline{Bj}$) und dem Ausgang des
der jeweiligen internen Bitleitung (Bj,$\overline{Bj}$) zugeordneten Bitleitungsdekoders (BLDEC) angeordnet ist, daß der andere Transistor zwischen
dem Versorgungspotential (VCC) der Schaltungsanordnung und den Gateanschlüssen des
Transfertransistorpaares (TTj) angeordnet ist
und daß die Gates beider Transistoren des
weiteren Transfertransistorpaares (WTTj) mit
einem dritten Ausgangssignal (T3) der Steuerschaltung (SS) verbunden sind.

11. Schaltungsanordnung nach einem der Ansprüche 6 bis 9, **dadurch gekennzeichnet**, daß
die Umschalteeinrichtung (US) ein weiteres
Transfertransistorpaar (WTTj) mit zwei zueinander komplementären Transistoren je interne
Bitleitung (Bj,$\overline{Bj}$) aufweist, daß je weiterem
Transfertransistorpaar (WTTj) Source und
Drain des einen Transistors zwischen den Gateanschlüssen des Transfertransistorpaares
(TTj) einer internen Bitleitung (Bj,$\overline{Bj}$) und dem
Ausgang des der jeweiligen internen Bitleitung
(Bj,$\overline{Bj}$) zugeordneten Bitleitungsdekoders
(BLDEC) angeordnet ist, daß der andere Transistor zwischen dem Versorgungspotential
(VCC) der Schaltungsanordnung und den Gateanschlüssen des Transfertransistorpaares
(TTj) angeordnet ist und daß die Gates der
Transistoren aller weiteren Transfertransistorpaare (WTTj) gruppenweise mit dritten Aus-

gangssignalen (T3',T3'',T3''') der Steuerschaltung (SS) verbunden sind.

12. Schaltungsanordnung nach einem der Ansprüche 6 bis 11, **dadurch gekennzeichnet**, daß sie des weiteren eine Wortleitungs-Adreßtrennerschaltung (WLTS) enthält, die eingangsmäßig einerseits mit einem vierten Ausgangssignal (T4) der Steuerschaltung (SS) verbunden ist und andererseits mit Adreßleitungen (A0 bis AM,$\overline{A0}$ bis $\overline{AM}$) verbunden ist, die der Adressierung der Wortleitungen (WIi) dienen, daß sie im Normalbetrieb die Adreßleitungen (A0 bis AM,$\overline{A0}$ bis $\overline{AM}$) auf die Wortleitungsdekoder (WLDEC) durchschaltet und im Testbetrieb einerseits die Adreßleitungen (A0 bis AM,$\overline{A0}$ bis $\overline{AM}$) blockiert und andererseits die Wortleitungsdekoder (WLDEC) so ansteuert, daß diese zum Einschreiben eine Wortleitung (WLi) oder eine Gruppe von Wortleitungen (WLi) nach der anderen ansteuern.

13. Schaltungsanordnung nach einem der Ansprüche 6 bis 11, **dadurch gekennzeichnet**, daß sie des weiteren eine Wortleitungs-Adreßtrennerschaltung (WLTS) enthält, die eingangsmäßig einerseits mit einem vierten Ausgangssignal (T4) der Steuerschaltung (SS) verbunden ist und andererseits mit Adreßleitungen (A0 bis AM,$\overline{A0}$ bis $\overline{AM}$) verbunden ist, die der Adressierung der Wortleitung (WLi) dienen, daß sie im Normalbetrieb die Adreßleitungen (A0 bis AM,$\overline{A0}$ bis $\overline{AM}$) auf die Wortleitungsdekoder (WLDEC) durchschaltet und im Testbetrieb einerseits die Adreßleitungen (A0 bis AM,$\overline{A0}$ bis $\overline{AM}$) blockiert und andererseits alle Wortleitungsdekoder (WLDEC) parallel ansteuert, so daß diese zum Einschreiben alle Wortleitungen (WLi) gleichzeitig ansteuern.

## Claims

1. Method for the parallel input of data items in the form of a test pattern into a block of a plurality of storage cells of a semiconductor memory having the following features:
   a) all internal evaluator circuits (BWSint) are switched to the inactive state,
   b) all internal bit lines (Bj, $\overline{Bj}$) are precharged to a precharge level,
   c) the first half (XB) of an external collective bit line is charged to a first logic level (D) and the second half ($\overline{XB}$) of the external collective bit line is charged to a second logic level ($\overline{D}$) complementary to the first logic level (D), at least one of the logic levels (D, $\overline{D}$) corresponding to the data items to be input,

   d) a transfer transistor pair (TTj) associated in each case with the internal evaluator circuit (BWSint) is switched so as to be electrically conductive for at least two internal evaluator circuits (BWSint) and a maximum of all internal evaluator circuits (BWSint), as a result of which the logic levels (D, $\overline{D}$) present on the external collective bit line (XB, $\overline{XB}$) reach the internal bit lines (Bj, $\overline{Bj}$) connected to the switched-through transfer transistor pairs (TTj),
   e) while driving at least one word line (WLi), inputting occurs of the desired data items into those storage cells (SZ) which are connected both to a driven word line (WLi) and to those internal bit lines (Bj, $\overline{Bj}$) whose associated transfer transistor pair (TTj) is switched so as to be electrically conductive,
   f) step (e) is performed while driving in each case at least one word line (WLi) previously not yet driven until all those storage cells (SZ) of the block (B) of the semiconductor memory have been written into which permit writing in on the basis of the selected assignment between the external collective bit line (XB, $\overline{XB}$) and the two logic levels (D, $\overline{D}$),
   g) repetition of the steps from feature b), exchanging the originally selected assignment between the external collective bit line (XB, $\overline{XB}$) and the two logic levels (D, $\overline{D}$) if the desired test pattern has not yet been written into all of the storage cells (SZ) after feature f) was carried out the last time.

2. Method according to Claim 1, characterised in that, for speeding up the input of the data items into the storage cells (SZ), after step d) of Patent Claim 1 at least those internal evaluator circuits (BWSint) whose associated transfer transistor pairs (TTj) have been switched so as to be electrically conductive are switched to the active state, and in that the repetition of steps in accordance with feature g) of Patent Claim 1 is carried out already from feature a) of Patent Claim 1.

3. Method according to Claim 1 or Claim 2, characterised in that logic "0" is selected as the first logic level (D) for the first execution of the method.

4. Method according to Claim 1 or 2, characterised in that logic '1' is selected as the first logic level (D) for the first execution of the method.

5. Method according to one of the preceding claims, characterised in that in the case of semiconductor memories having a plurality of mutually identical storage blocks (B), the method is applied simultaneously and in parallel to these storage blocks (B).

6. Circuit arrangement, in particular for carrying out the method according to one of the preceding claims, having the following features:
   - a semiconductor memory contains at least one block (B) of $2^{N+M}$ storage cells (SZ) disposed in the form of a matrix,
   - the storage cells (SZ) can be addressed via word lines (WLi) and internal bit lines (Bj, $\overline{Bj}$),
   - each internal bit line (Bj, $\overline{Bj}$) is assigned an internal evaluator circuit (BWSint) which divides the internal bit line (Bj, $\overline{Bj}$) into two halves,
   - each internal evaluator circuit (BWSint) is connected via a transfer transistor pair (TTj) to an external collective bit line (XB, $\overline{XB}$) shared by all transfer transistor pairs (TTj),
   - connected to the external collective bit line (XB, $\overline{XB}$) is an external evaluator circuit (BWSext), which serves both, when data items are read out of the semiconductor memory, to amplify the data item read out and finally to forward the amplified data item (D0), and, when data items are input into the semiconductor memory in the form of logic levels (D, $\overline{D}$), to transfer the data item to be written in from a data input circuit (DIN) and to forward it to the external collective bit line (XB, $\overline{XB}$),
   - the word lines (WLi) can be activated by word line decoders (WLDEC) and the internal bit lines (Bj, $\overline{Bj}$) can be activated by bit line decoders (BLDEC),

   characterised by the following features:
   - the data input circuit (DIN) is connected via in each case one switching transistor (ST) to potentials (POT1, POT2), the values of which are associated with the two logic levels (D, $\overline{D}$),
   - a control circuit (SS) is connected on the input side to control signals (P1, ..., Pk),
   - the control signals (P1, ..., Pk) contain information relating to whether parallel input is to be performed and which test pattern is to be used therefor,
   - the control circuit (SS) has a first output signal (T1) which drives the switching transistors (ST),
   - it has a second output signal (T2) which is connected to the data input circuit (DIN) and which controls within the data input circuit (DIN) which of the potentials (POT1, POT2) generated via the switching transistors (ST) is to be applied as first logic level (D) via the external evaluator circuit (BWSext) to a first half (XB) of the external collective bit line, and which furthermore controls which of the potentials (POT1, POT2) generated via the switching transistors (ST) is to be applied as second logic level ($\overline{D}$) via the external evaluator circuit (BWSext) to a second half ($\overline{XB}$) of the external collective bit line,
   - the bit line decoders (BLDEC) are provided with a switch-over device (US) for the parallel activation of at least a plurality of, up to a maximum of all, transfer transistor pairs (TTj) via a third output signal (T3) of the control circuit (SS).

7. Circuit arrangement according to Claim 6, characterised in that the control circuit (SS) contains a decoder section (DEC) which evaluates the control signals (P1, ..., Pk).

8. Circuit arrangement according to Claim 6 or 7, characterised in that the control circuit (SS) contains a PLA circuit.

9. Circuit arrangement according to Claim 6 or 7, characterised in that the control circuit (SS) contains a non-volatile storage circuit.

10. Circuit arrangement according to one of Claims 6 to 9, characterised in that the switchover device (US) has a further transfer transistor pair (WTTj) with two mutually complementary transistors for each internal bit line (Bj, $\overline{Bj}$) in that for each further transistor pair (WTTj), source and drain of the one transistor are disposed between the gate terminals of the transfer transistor pair (TTj) of an internal bit line (Bj, $\overline{Bj}$) and the output of the bit line decoder (BLDEC) associated with the output of the respective internal bit line (Bj, $\overline{Bj}$), in that the other transistor is disposed between the supply potential (VCC) of the circuit arrangement and the gate terminals of the transfer transistor pair (TTj), and in that the gates of both transistors of the further transfer transistor pair (WTTj) are connected to a third output signal (T3) of the control circuit (SS).

11. Circuit arrangement according to one of Claims 6 to 9, characterised in that the switchover device (US) has a further transfer transistor pair (WTTj) with two mutually complementary transistors for each internal bit line (Bj, $\overline{Bj}$), in that for each further transfer transistor pair (WTTj), source and drain of the one transistor are disposed between the gate terminals of the transfer transistor pair (TTj) of an internal bit line (Bj, $\overline{Bj}$) and the output of the bit line decoder (BLDEC) associated with the respective internal bit line (Bj, $\overline{Bj}$), in that the other transistor is disposed between the supply potential (VCC) of the circuit arrangement and the gate terminals of the transfer transistor pair (TTj), and in that the gates of the transistors of all further transfer transistor pairs (WTTj) are connected in groups to third output signals (T3', T3'',T3''') of the control circuit (SS).

12. Circuit arrangement according to one of Claims 6 to 11, characterised in that it furthermore contains a word line address separating circuit (WLTS) which is connected on the input side on the one hand to a fourth output signal (T4) of the control circuit (SS) and on the other hand to address lines (A0 to AM, $\overline{A0}$ to $\overline{AM}$), and which serves for addressing the word lines (WLi), in that it switches through the address lines (A0 to AM, $\overline{A0}$ to $\overline{AM}$) to the word line decoders (WLDEC) in normal operation, and in test operation on the one hand blocks the address lines (A0 to AM, $\overline{A0}$ to $\overline{AM}$) and on the other hand drives the word line decoders (WLDEC) in such a way that they drive a word line (WLi) or a group of word lines (WLi) one after the other for input.

13. Circuit arrangement according to one of Claims 6 to 11, characterised in that it furthermore contains a word line address separating circuit (WLTS) which is connected on the input side on the one hand to a fourth output signal (T4) of the control circuit (SS) and on the other hand to address lines (A0 to AM, $\overline{A0}$ to $\overline{AM}$) which serve for addressing the word lines (WLi), in that it switches through the address lines (A0 to AM, $\overline{A0}$ to $\overline{AM}$) to the word line decoders (WLDEC) in normal operation, and in test operation on the one hand blocks the address lines (A0 to AM, $\overline{A0}$ to $\overline{AM}$) and on the other hand drives all word line decoders (WLDEC) in parallel so that they drive all word lines (WLi) simultaneously for input.

## Revendications

1. Procédé pour enregistrer en parallèle des données sous la forme d'un profil de contrôle dans un bloc de plusieurs cellules d'une mémoire à semiconducteurs, présentant les caractéristiques suivantes:

a) tous les circuits internes d'évaluation (BWSint) sont branchés à l'état inactif,

b) tous les conducteurs internes de transmission de Dits (Bj, $\overline{Bj}$) sont préchargés à un niveau de précharge,

c) la première moitié (XB) d'un conducteur formant bus externe de transmission de bit est chargée à un premier niveau logique (D) et la seconde moitié ($\overline{XB}$) du conducteur formant bus externe de transmission de bits est chargée à un second niveau logique ($\overline{D}$), qui est complémentaire du premier niveau logique (D), au moins l'un des niveaux logiques (D,$\overline{D}$) correspondant aux données devant être enregistrées,

d) pour au moins deux circuits internes d'évaluation (BWSint) et pour au maximum tous les circuits internes d'évaluation (BWSint), un couple de transistors de transfert (TTj), associé respectivement au circuit interne d'évaluation (BWSint) est branché à l'état électriquement conducteur, ce qui a pour effet que les niveaux logiques (D,$\overline{D}$) appliqués au conducteur formant bus externe de transmission de Dits (XB,$\overline{XB}$) parviennent aux conducteurs internes de transmission de bits (Bj, $\overline{Bj}$) raccordés aux couples de transistors de transfert (TTj) rendus passants,

e) l'enregistrement des données désirées est réalisé sous la commande d'au moins un conducteur de transmission de mots (WLi), dans les cellules de mémoire (SZ), qui sont raccordées aussi bien à un conducteur commandé de transmission de mots (WLi) qu'à des conducteurs internes de transmission de bits (Bj, $\overline{Bj}$), dont le couple associé de transistors de transfert (TTj) est placé à l'état électriquement conducteur,

f) le pas (e) est exécuté suffisamment fréquemment sous la commande respectivement d'au moins un conducteur de transmission de mots (WLi) non encore commandé au préalable, jusqu'à ce que soient enregistrés les cellules de mémoire (SZ) du bloc (B) de la mémoire à semiconducteurs, dont l'enregistrement est possible sur la base de l'association sélectionnée entre le conducteur formant bus externe de transmission de bits (X2, $\overline{X2}$) et les deux niveaux logiques (D, $\overline{D}$),

g) les pas sont répétés, à partir de la caractéristique b), moyennant une permutation de l'association choisie initialement entre le conducteur formant bus externe de transmission de Dits (XB, $\overline{XB}$), et les deux niveaux logiques (D, $\overline{D}$), dans le cas où, lors de la dernière mise en oeuvre de la caractéristique f, toutes les cellules de mémoire (SZ) ne sont pas encore enregistrées avec le profil binaire désiré.

2. Procédé suivant la revendication 1, caractérisé par le fait que pour accélérer l'enregistrement des données dans les cellules de mémoire (SZ), après le pas d) de la revendication 1, on branche à l'état actif au moins les circuits internes d'évaluation (BWSint), dont les couples associés de transistors de transfert (TTj) sont placés à l'état électriquement conducteur, et que la répétition de pas conformément à la caractéristique g) de la revendication 1 s'effectue déjà à partir de la caractéristique a) de la revendication 1.

3. Procédé suivant la revendication 1 ou 2, caractérisé par le fait qu'on choisit comme premier niveau logique (D), lors de la première exécution du procédé, le "0" logique.

4. Procédé suivant la revendication 1 ou 2, caractérisé par le fait qu'on choisit comme premier niveau logique (D) lors de la première exécution du procédé, le "1" logique.

5. Procédé suivant l'une des revendications précédentes, caractérisé par le fait que dans les mémoires à semiconducteurs comportant plusieurs blocs de mémoire identiques (B), on applique le procédé simultanément en parallèle à ces blocs de mémoire (B).

6. Montage, notamment pour la mise en oeuvre du procédé suivant l'une des revendications précédentes, caractérisé par les caractéristiques suivantes:
   - une mémoire à semiconducteurs contient au moins un bloc (B) de $2^{N+M}$ cellules de mémoire (SZ) disposées sous la forme d'une matrice,
   - des cellules de mémoire (SZ) peuvent être adressées par l'intermédiaire de conducteurs de transmission de mots (WLi) et de conducteurs internes de transmission de bits (Bj, $\overline{Bj}$),
   - à chaque conducteur interne de transmission de bits ($\overline{Bj}$, $\overline{Bj}$) est associé un circuit interne d'évaluation (BWSint), qui subdivise le conducteur interne de transmission de bits (Bj, $\overline{Bj}$) en deux moitiés,
   - chaque circuit interne d'évaluation (BWSint) est raccordé par l'intermédiaire d'un couple de transistors de transfert (TTj) à un conducteur formant bus de transmission de bits (XB, $\overline{XB}$), comme à

tous les couples de transistors de transfert (TTj),
   - au conducteur formant bus externe de transmission de bits (XB, $\overline{XB}$) est raccordé un circuit externe d'évaluation (BWSext), qui est utilisé, aussi bien dans le cas de la lecture de données à partir de la mémoire à semiconducteurs, pour amplifier la donnée lue et finalement à reproduire la donnée amplifiée (DO), que dans le cas de l'enregistrement de données sous la forme de niveaux logiques (D, $\overline{D}$) dans la mémoire à semiconducteurs, pour prendre en charge la donnée devant être enregistrée, à partir d'un circuit d'entrée de données (DIN) et à transférer cette donnée au conducteur formant bus externe de transmission de Dits (XB, $\overline{XB}$),
   - les conducteurs de transmission de mots (WLi) peuvent être activés au moyen de décodeurs (WLDEC) des conducteurs de transmission de mots et les conducteurs internes de transmission de Dits (Bj, $\overline{Bj}$) peuvent être activés par des décodeurs (BLDEC) des conducteurs de transmission de bits,
caractérisé par les caractéristiques suivantes:
   - le circuit d'entrée de données (DIN) est raccordé par l'intermédiaire d'un transistor respectif de commutation (ST) à des potentiels (POT1, POT2), dont les valeurs sont associées aux deux niveaux logiques (D, $\overline{D}$),
   - un circuit de commande (SS) reçoit, côté entrée, des signaux de commande (P1,...,Pk),
   - les signaux de commande (P1,...,Pk) contiennent des informations indiquant si l'enregistrement en parallèle doit être exécuté et quel profil de contrôle doit être alors utilisé,
   - le circuit de commande (SS) fournit un premier signal de sortie (T1), qui commande les transistors de commutation (ST),
   - il possède un second signal de sortie (T1), qui est appliqué au circuit de données d'entrée (DIN) et commande, à l'intérieur de ce circuit (DIN), celui des potentiels (POT1,POT2), appliqué par l'intermédiaire des transistors de commutation (ST), qui doit être appliqué en tant que premier niveau logique (D), par l'intermédiaire du circuit externe d'évaluation (BWSext), à une première moitié (XB) du conducteur formant bus externe de transmission de bits, et commande en outre celui du potentiel (POT1,POT2) appliqué par l'intermédiaire des transistors de commutation (ST), qui doit être appliqué en tant que second niveau logique (D̄) par l'intermédiaire du circuit externe d'évaluation (BWSext) à une seconde moitié (XB) du conducteur formant bus externe de transmission de bits,

- les décodeurs (BLDEC) des conducteurs de transmission de bits sont équipés d'un dispositif de commutation (US) qui sert à activer en parallèle au moins plusieurs et au maximum tous les couples de transistors de transfert (TTj) par l'intermédiaire d'un troisième signal de sortie (T3) du circuit de commande (SS).

7. Montage suivant la revendication 6, caractérisé par le fait que le circuit de commande (SS) contient une partie formant décodeur (DEC), qui évalue les signaux de commande (P1,...,Pk).

8. Montage suivant la revendication 6 ou 7, caractérisé par le fait que le circuit de commande (SS) contient un circuit PLA.

9. Montage suivant la revendication 6 ou 7, caractérisé par le fait que le circuit de commande (SS) contient un circuit de mémoire non volatile.

10. Montage suivant l'une des revendications 6 à 9, caractérisé par le fait que le dispositif de commutation (US) comporte un autre couple de transistors de transfert (WTTj) comprenant deux transistors complémentaires l'un à l'autre pour chaque conducteur interne de transmission de Dits (Bj, B̄j), que pour chaque autre couple de transistors (WTTj), la source et le drain d'un transistor sont disposés entre les bornes de grille du couple de transistors de transfert (TTj) d'un conducteur interne de transmission de Dits (Bj,B̄j) et la sortie du décodeur de conducteurs de transmission de bits (BLDEC), associé à la sortie du conducteur interne respectif de transmission de bits (Bj,B̄j), que l'autre transistor est disposé entre le potentiel d'alimentation (VCC) du montage et les bornes de grille du couple de transistors de transfert (TTj), et que les grilles des deux transistors de l'autre couple de transistors de transfert (WTTj) reçoive un troisième signal de sortie (T3) du circuit de commande (SS).

11. Montage suivant l'une des revendications 6 à 9, caractérisé par le fait que le dispositif de commutation (US) comporte un autre couple de transistors de transfert (WTTj) comportant deux transistors complémentaires l'un à l'autre pour chaque conducteur interne de transmission de bits (Bj, B̄j), que pour chaque autre couple de transistors de transfert (WTTj), la source et le drain d'un transistor sont disposés entre les bornes de grille du couple de transistors de transfert (TTj) d'un conducteur interne de transmission de bits (Bj,B̄j) et la sortie du décodeur (BLDEC) des conducteurs de transmission de bits, associé au conducteur interne respectif de transmission de bits (Bj,B̄j), que l'autre transistor est disposé entre le potentiel d'alimentation (VCC) du montage et les bornes de grille du couple de transistors de transfert (TTj), et que les grilles des transistors de tous les autres couples de transistors de transfert (WTTj) reçoivent, par groupes, des troisièmes signaux de sortie (T3',T3",T3"') du circuit de commande (SS).

12. Montage suivant l'une des revendications 6 à 11, caractérisé par le fait qu'il contient d'autre part un circuit (WLTS) de séparation des adresses des conducteurs de transmission de mots, qui, côté entrée, d'une part reçoit un quatrième signal de sortie (T4) du circuit de commande (SS) et d'autre part est raccordé à des conducteurs de transmission d'adresses (A0 à AM, Ā0 à ĀM), qui servent à réaliser l'adressage des conducteurs de transmission de mots (W1i), que pendant le fonctionnement normal, il réalise l'interconnexion directe des conducteurs de transmission d'adresses (A0 à AM, Ā0 à ĀM) aux décodeurs (WLDEC) des conducteurs de transmission de mots et, pendant le fonctionnement de test, d'une part bloque les conducteurs d'adresses de transmission d'adresses (A0 à AM, Ā0 à ĀM) et commande d'autre part les décodeurs (WLDEC) des conducteurs de transmission de mots de manière que ces derniers commandent successivement, pour l'enregistrement, un conducteur de transmission de mots (WLi) ou un groupe de conducteurs de transmission de mots (WLi).

13. Montage suivant l'une des revendications 6 à 11, caractérisé par le fait qu'il contient en outre un circuit (WLTS) de séparation des adresses des conducteurs de transmission de mots, qui, côté entrée, d'une part reçoit un quatrième signal de sortie (T4) du circuit de commande (SS) et d'autre part est raccordé à des conducteurs de transmission d'adresses (A0 à AM, Ā0 à ĀM), qui sont utilisés pour l'adressage des conducteurs de transmission de mots (WLi), que pendant le fonctionnement normal, il interconnecte directement les conducteurs de transmission d'adresses (A0 à AM, $\overline{A0}$ à $\overline{AM}$) aux décodeurs (WLDEC) des conducteurs de transmission de mots et, lors du fonctionnement de test, d'une part bloque les conducteurs de transmission d'adresses (A0 à AM, $\overline{A0}$ à $\overline{AM}$) et d'autre part commande en parallèle tous les décodeurs (WLDEC) des conducteurs de transmission de mots de manière que ces derniers commandent simultanément, pour l'enregistrement, tous les conducteurs de transmission de mots (WLi).

# FIG 1

# FIG 3

# FIG 2

# FIG 4